(19) Europäisches Patentamt
European Patent Office
Office européen des brevets

(11) **EP 4 742 467 A1**

(12) **EUROPEAN PATENT APPLICATION**
published in accordance with Art. 153(4) EPC

(43) Date of publication:
**13.05.2026 Bulletin 2026/20**

(21) Application number: **24844757.5**

(22) Date of filing: **22.07.2024**

(51) International Patent Classification (IPC):
**H01S 5/0239** (2021.01)

(52) Cooperative Patent Classification (CPC):
**G02B 27/01; H01S 5/02208; H01S 5/02315; H01S 5/0239; H04B 10/40; H04B 10/50; H04N 9/31**

(86) International application number:
**PCT/CN2024/106737**

(87) International publication number:
**WO 2025/021066 (30.01.2025 Gazette 2025/05)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **26.07.2023 CN 202310928570**

(71) Applicant: **Huawei Technologies Co., Ltd.**
**Shenzhen, Guangdong 518129 (CN)**

(72) Inventors:
• ZHU, Dingjun
  Shenzhen, Guangdong 518129 (CN)
• JIANG, Hongxing
  Shenzhen, Guangdong 518129 (CN)
• ZHOU, Dangqun
  Shenzhen, Guangdong 518129 (CN)

(74) Representative: **Goddar, Heinz J.**
**Boehmert & Boehmert**
**Anwaltspartnerschaft mbB**
**Pettenkoferstrasse 22**
**80336 München (DE)**

(54) **LIGHT SOURCE, PHOTOELECTRIC CONVERSION APPARATUS, RELATED DEVICE AND SYSTEM**

(57)     A light source, a photoelectric conversion apparatus, a related device, and a system are provided. The light source includes a first substrate (302), a drive circuit, and a first laser (202). Two surfaces of the first substrate (302), namely, a first surface (321) and a second surface (322), are respectively located in a first packaging space (311) and a second packaging space (312). The first laser (202) is packaged in the first packaging space (311) or the second packaging space (312), and the drive circuit is packaged in at least one of the first packaging space (311) and the second packaging space (312). In addition, a packaging space in which the first laser (202) is packaged is different from a packaging space in which at least a part of the drive circuit is packaged. The drive circuit is electrically connected to the first laser (202) through the first substrate (302), to drive the first laser (202) to emit light, to increase peak optical power output by the light source when a size of the light source can be effectively reduced.

FIG. 3

## Description

This application claims priority to Chinese Patent Application No. CN202310928570.6, filed with the China National Intellectual Property Administration on July 26, 2023 and entitled "LIGHT SOURCE, PHOTOELECTRIC CONVERSION APPARATUS, RELATED DEVICE, AND SYSTEM", which is incorporated herein by reference in its entirety.

## TECHNICAL FIELD

This application relates to the field of optical communication technologies, and in particular, to a light source, a photoelectric conversion apparatus, a related device, and a system.

## BACKGROUND

Light sources used to emit lasers are used in an increasingly wide range of fields. For example, the light source is used in a radar, a passive optical network (passive optical network, PON), an optical transport network (optical transport network, OTN), an industrial optical network, and the like. An example in which the light source is used in a radar is used. Peak optical power output by the light source is in a positive correlation with a detection range of the radar. Therefore, increasing the peak optical power output by the light source can increase the detection range of the radar.

The light source includes a laser and a heat sink. The heat sink is configured to dissipate heat for the laser, to ensure that the laser is always within a preset temperature range, so that peak optical power output by the laser is increased. For example, the heat sink is attached to the laser, and the heat sink may implement heat dissipation for the laser through a water cooling passage.

To increase the peak optical power output by the laser, a quantity of lasers needs to be increased. When the quantity of lasers is increased, to ensure heat dissipation for the lasers, a size of the heat sink needs to be increased. Increasing the size of the heat sink included in the light source causes a problem of an increased size of the light source. In addition, using only the heat sink to increase the peak optical power output by the laser has limited effect on increasing the peak optical power output by the laser.

## SUMMARY

Embodiments of this application provide a light source, a photoelectric conversion apparatus, a related device, and a system, to increase peak optical power output by the light source when a size of the light source is effectively reduced.

According to a first aspect, an embodiment of this application provides a light source that includes a first substrate, a drive circuit, and a first laser. The drive circuit is electrically connected to the first laser through the first substrate, and the drive circuit is configured to drive the first laser to emit light. The light source includes a first packaging space and a second packaging space that are stacked in a direction perpendicular to the first substrate, a first surface of the first substrate is located in the first packaging space, a second surface of the first substrate is located in the second packaging space, and an orientation of the first surface is opposite to an orientation of the second surface. The first laser is packaged in the first packaging space or the second packaging space, the drive circuit is packaged in at least one of the first packaging space and the second packaging space, and a packaging space in which the first laser is packaged is different from a packaging space in which at least a part of the drive circuit is packaged. It may be understood that a packaging manner of the first laser and the drive circuit may be the following example. For example, the first laser is packaged in the first packaging space, and the drive circuit is packaged in the second packaging space. For another example, the first laser is packaged in the first packaging space, a part of the drive circuit is packaged in the first packaging space, and the other part is packaged in the second packaging space. For another example, the first laser is packaged in the second packaging space, and the drive circuit is packaged in the first packaging space. For another example, the first laser is packaged in the second packaging space, a part of the drive circuit is packaged in the first packaging space, and the other part is packaged in the second packaging space.

As shown in this aspect, the drive circuit is electrically connected to the first laser directly through the first substrate, so that a physical length of an electrical connection loop between the drive circuit and the first laser is short. The physical length of the electrical connection loop between the drive circuit and the first laser is in a negative correlation with a drive current. The drive current is used to drive the first laser to emit light. The drive current is in a positive correlation with a peak optical power output by the first laser. In this case, when the physical length of the electrical connection loop between the drive circuit and the first laser is short, the peak optical power output by the first laser is effectively increased. It may be understood that, according to the light source shown in this aspect, peak optical power output by a single first laser included in the light source can be increased. In this way, peak optical power output by the light source as a whole is increased when a quantity of first lasers included in the light source is not changed.

Based on the first aspect, in an optional implementation, in the direction perpendicular to the first substrate, the light source further includes a circuit board stacked with the first substrate, a surface that is of the circuit board and that faces the first substrate is located in the first packaging space, and the first surface is a surface that is of the first substrate and that faces the circuit board.

As shown in this aspect, when the light source includes the circuit board, the first packaging space is formed between the circuit board and the first substrate. Specifically, the surface that is of the circuit board and that faces the substrate and the first surface are located in the first packaging space, to ensure that the drive circuit and the first laser are directly electrically connected through the first substrate. In this way, the physical length of the electrical connection loop between the drive circuit and the first laser is effectively reduced, to increase the peak optical power output by the light source as a whole.

Based on the first aspect, in an optional implementation, in the direction perpendicular to the first substrate, the first substrate includes at least a first sub-substrate and a second sub-substrate that are stacked, the first sub-substrate includes a first current channel passing through the first sub-substrate, the second sub-substrate includes a second current channel passing through the second sub-substrate, any one of a plurality of first current channels is electrically connected to one of a plurality of second current channels, and the drive circuit is electrically connected to the first laser through the first current channel and the second current channel.

The first substrate shown in this implementation is used to implement an electrical connection between the drive circuit and the first laser in the direction perpendicular to the first substrate. In this way, the physical length of the electrical connection loop between the drive circuit and the first laser is effectively reduced, to effectively increase the peak optical power output by the light source as a whole.

Based on the first aspect, in an optional implementation, a first orthographic projection partially overlaps with a second orthographic projection, the first orthographic projection is an orthographic projection of the any one of the plurality of first current channels, and the second orthographic projection is an orthographic projection of the one of the plurality of second current channels.

In this implementation, when the first sub-substrate includes a plurality of first current channels, the second sub-substrate includes a plurality of second current channels, and the first orthographic projection partially overlaps with the second orthographic projection, uniformity of a current flowing through the first substrate is effectively improved, so that parasitic inductance of the drive circuit is effectively reduced and the peak optical power output by the light source as a whole is increased.

Based on the first aspect, in an optional implementation, the drive circuit includes a first electrical module and a second electrical module, the first electrical module is packaged in the first packaging space, and the second electrical module is packaged in the second packaging space.

In this implementation, the drive circuit is packaged in the first packaging space and the second packaging space. In this way, the physical length of the electrical connection loop between the drive circuit and the first laser is effectively reduced, to effectively increase the peak optical power output by the light source as a whole.

Based on the first aspect, in an optional implementation, the first laser is packaged in the first packaging space, and the drive circuit is packaged in the second packaging space; or the first laser is packaged in the second packaging space, and the drive circuit is packaged in the first packaging space.

In this implementation, the drive circuit and the first laser are packaged in different packaging spaces. In this way, the physical length of the electrical connection loop between the drive circuit and the first laser can be reduced, to effectively increase the peak optical power output by the light source as a whole.

Based on the first aspect, in an optional implementation, the light source further includes a second laser electrically connected to the drive circuit, the drive circuit is electrically connected to the second laser through the first substrate, and the drive circuit is further configured to drive the second laser to emit light. The second laser is packaged in the first packaging space or the second packaging space.

In this implementation, the light source includes a plurality of lasers, and each laser is directly electrically connected to the drive circuit through the first substrate. This effectively increases the peak optical power output by the light source as a whole, and improves integration of a plurality of lasers packaged by the light source.

Based on the first aspect, in an optional implementation, in the direction perpendicular to the first substrate, the light source further includes a second substrate stacked with the first substrate, the second packaging space includes a first packaging subspace and a second packaging subspace, a third surface of the second substrate and the second surface are located in the first packaging subspace, the third surface is a surface that is of the second substrate and that faces the first substrate, a fourth surface of the second substrate is located in the second packaging subspace, and an orientation of the third surface is opposite to an orientation of the fourth surface. The first laser is packaged in one of the first packaging space, the first packaging subspace, and the second packaging subspace, and the drive circuit is packaged in at least one of the first packaging space, the first packaging subspace, and the second packaging subspace.

In this implementation, the first laser is packaged in one of the first packaging space, the first packaging subspace, and the second packaging subspace, and the drive circuit is packaged in at least one of the first packaging space, the first packaging subspace, and the second packaging subspace. This effectively reduces the physical length of the electrical connection loop between the first laser and the drive circuit, to improve integration of the light source.

Based on the first aspect, in an optional implementation, the light source further includes a heat sink configured to dissipate heat for the first laser. The heat sink is packaged on a surface that is of the circuit board and that faces away from the first substrate, and the heat sink includes at least one of an air cooling system, a water cooling system, a thermoelectric cooler TEC, a heat sink fin, or an electric cooler.

According to a second aspect, an embodiment of this application provides a photoelectric conversion apparatus that includes a processing module, a modulation module, a demodulation module, a transmit port, a receive port, and the light source according to any implementation of the first aspect, where the processing module is connected to the modulation module and the demodulation module, the modulation module is connected to the light source and the transmit port, and the demodulation module is connected to the receive port. The processing module is configured to send a first service electrical signal to the modulation module. The light source is configured to send an optical signal to the modulation module. The modulation module is configured to modulate the first service electrical signal onto the optical signal to obtain a first service optical signal. The transmit port is configured to emit the first service optical signal. The receive port is configured to receive a second service optical signal. The demodulation module is configured to demodulate the second service optical signal into a second service electrical signal, and send the second service electrical signal to the processing module. For descriptions of beneficial effects of this aspect, refer to the descriptions shown in the first aspect. Details are not described again.

For descriptions of beneficial effects of this aspect, refer to the descriptions shown in the first aspect. Details are not described again.

According to a third aspect, an embodiment of this application provides an optical communication device that includes an outer housing, a processor, and the photoelectric conversion apparatus according to any implementation of the first aspect, where the outer housing is configured to fasten the processor to the photoelectric conversion apparatus, and the processor is connected to the photoelectric conversion apparatus. The processor is configured to send the first service electrical signal to the photoelectric conversion apparatus, and is further configured to receive the second service electrical signal from the photoelectric conversion apparatus.

According to a fourth aspect, an embodiment of this application provides a radar that includes a controller, a receiving apparatus, and the light source according to any implementation of the first aspect, and the controller is connected to the light source and the receiving apparatus. The light source is configured to emit a laser beam. The receiving apparatus is configured to receive an echo light beam, and is configured to perform photoelectric conversion on the echo light beam to obtain a detection electrical signal, where a to-be-detected object is configured to reflect the laser beam to reflect the echo light beam to the receiving apparatus. The controller is configured to detect the to-be-detected object based on the detection electrical signal.

According to a fifth aspect, an embodiment of this application provides a projection system that includes an image modulation module, a lens, and the light source according to any implementation of the first aspect. The image modulation module is configured to receive a projected light beam from the light source, is configured to modulate the projected light beam to obtain a modulated light beam, and is further configured to transmit the modulated light beam to the lens. The lens is configured to perform imaging on the modulated light beam.

According to a sixth aspect, an embodiment of this application provides a head-up display system that includes an optical deflection module and the projection system according to any implementation of the first aspect. The projection system is configured to transmit the modulated light beam to the optical deflection module. The optical deflection module is configured to transmit an amplified modulated light beam to a windshield, where the modulated light beam reflected by the windshield forms a virtual image.

According to a seventh aspect, an embodiment of this application provides a transportation means that includes a vehicle body, a windshield, a processor, and the head-up display system according to any implementation of the first aspect. The vehicle body is configured to fasten the windshield, the processor, and the head-up display system together. The processor is configured to transmit vehicle driving related information to the image modulation module. The image modulation module is configured to modulate the vehicle driving related information onto the projected light beam to obtain the modulated light beam.

According to an eighth aspect, an embodiment of this application provides an optical communication system. The optical communication system includes a plurality of optical communication devices, and in the plurality of optical communication devices, two optical communication devices are connected through an optical cable. For descriptions of the optical communication device, refer to the third aspect. Details are not described again.

**BRIEF DESCRIPTION OF DRAWINGS**

FIG. 1 is an example diagram of a structure of a light source used in a vehicle according to this application;

FIG. 2 is an example diagram of a circuit connection structure of an embodiment of a light source according to this application;

FIG. 3 is an example diagram of a packaging structure of a first embodiment of a light source according to this application;

FIG. 4 is an example diagram of a packaging structure of a second embodiment of a light source according to this application;

FIG. 5 is an example diagram of a packaging structure of a third embodiment of a light source according to this application;

FIG. 6 is an example diagram of a packaging structure of a fourth embodiment of a light source according to this application;

FIG. 7 is an example diagram of a packaging structure of a fifth embodiment of a light source according to this application;

FIG. 8 is an example diagram of a packaging structure of a sixth embodiment of a light source according to this application;

FIG. 9 is an example diagram of a packaging structure of a seventh embodiment of a light source according to this application;

FIG. 10 is an example diagram of a packaging structure of an eighth embodiment of a light source according to this application;

FIG. 11 is an example diagram of a structure of an embodiment of a photoelectric conversion apparatus according to this application;

FIG. 12 is an example diagram of a structure of an embodiment of an optical communication system according to this application;

FIG. 13 is an example diagram of a structure of an embodiment of a radar according to this application;

FIG. 14 is an example diagram of a structure of an embodiment of a projection system according to this application; and

FIG. 15 is an example diagram of a structure of an embodiment of a head-up display system according to this application.

## DESCRIPTION OF EMBODIMENTS

The following clearly and completely describes the technical solutions in embodiments of this application with reference to the accompanying drawings in embodiments of this application. It is clear that the described embodiments are merely some but not all of embodiments of this application. All other embodiments obtained by a person skilled in the art based on embodiments of this application without creative efforts shall fall within the protection scope of this application.

This embodiment of this application provides a light source that can emit a laser. An example in which the light source is used in a transportation means is used for description. It should be noted that an application scenario of the light source is not limited in this embodiment. For example, the light source may alternatively be used in a data center network (data center network, DCN), a metropolitan area network, a PON, an OTN, or the like. This is not specifically limited. The transportation means shown in this example may be a car, a truck, a motorcycle, a bus, a lawn mower, an entertainment vehicle, a playground vehicle, a tram, a golf cart, a train, a handcart, an uncrewed aerial vehicle, or the like.

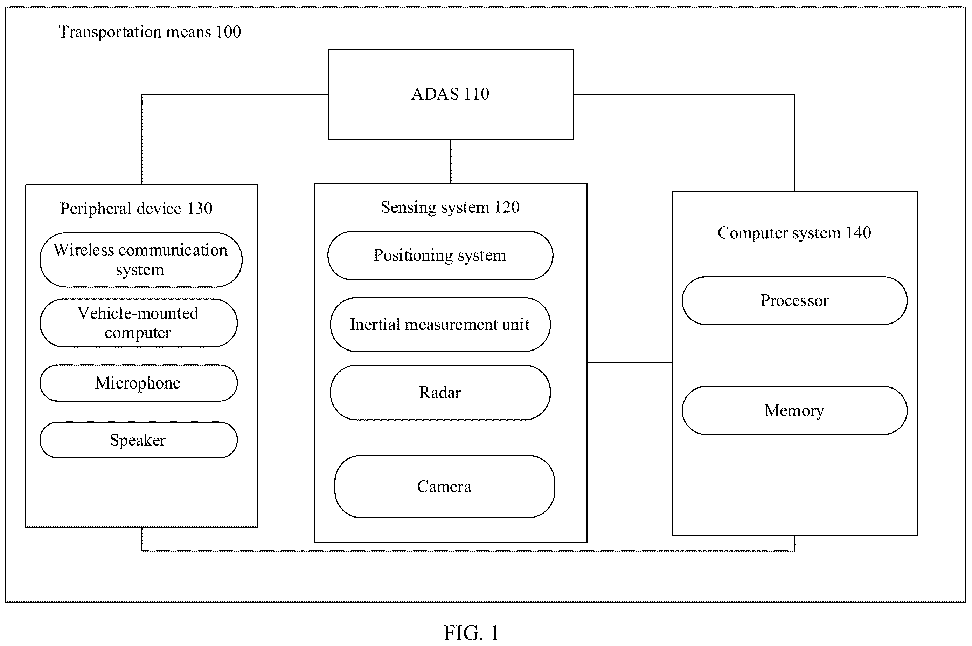

FIG. 1 is an example diagram of a structure of a light source used in a vehicle according to this application. In this embodiment, the transportation means 100 is configured to be in a fully or partially autonomous driving mode. The transportation means shown in this embodiment includes a vehicle body, and the vehicle body is configured to fasten the sensor system 120, an advanced driver-assistance system (advanced driving assistance system, ADAS) 110, a peripheral device 130, and a computer system 140 together.

The sensor system 120 includes one or more sensors that sense information about an ambient environment of the transportation means 100. For example, the sensor system 120 may include a positioning system, where the positioning system is any positioning system such as a global positioning system (global positioning system, GPS) system or a BeiDou system. The sensor system 120 further includes an inertial measurement unit (inertial measurement unit, IMU), a radar, a camera, and the like. The sensor system 120 may further include a sensor (for example, an in-vehicle air quality monitor, a fuel gauge, or an engine oil thermometer) configured to monitor an internal system of the transportation means 100. Sensor data from one or more of these sensors may be used to detect an object and corresponding features (a position, a shape, a direction, a speed, and the like) of the object. The positioning system may be configured to estimate a geographical location of the transportation means 100. The IMU is configured to sense a location change and an orientation change of the transportation means 100 based on inertial acceleration. The IMU may be a combination of an accelerometer and a gyroscope. The radar may detect, by using a radio signal, a to-be-detected object in an ambient environment of the transportation means 100. For example, the to-be-detected object may be a pedestrian, a transportation means, or a building. Optionally, the radar may be further configured to detect a speed and/or a forward direction of the to-be-detected object. A specific type of the radar is not limited in this embodiment. For example, the radar may be a millimeter-wave radar or a lidar. The camera may be configured to capture a plurality of images of an ambient environment of the transportation means 100. The camera may be a static camera, a video camera, a monocular/binocular camera, an infrared imager, or the like.

The ADAS 110 senses the ambient environment at any time during driving of the transportation means, collects data, identifies, detects, and tracks static and dynamic objects, and performs systematic computing and analysis based on the navigation map data. In this way, a driver can detect a potential danger in advance, so that comfort and safety of the transportation means is effectively improved. For example, the ADAS 110 may control the transportation means based on data obtained by the sensing system 120. For another example, the ADAS 110 may control the transportation means based on vehicle driving related information. The vehicle driving related information may be main data (fuel consumption, engine rotation speed, temperature, and the like), vehicle speed information, steering wheel angle information, vehicle body posture data, or the like on a dashboard of the transportation means.

The transportation means 100 interacts with an external sensor, another transportation means, another computer system, or a user through the peripheral device 130. The peripheral device 130 may include a wireless communication system, a vehicle-mounted computer, a microphone, and/or a speaker. For example, the vehicle-mounted computer may provide information to a user of the transportation means 100. The user interface may further operate the vehicle-mounted computer to receive an input from the user. The vehicle-mounted computer may perform an operation by using a touchscreen. In another case, the peripheral device 130 may provide a means for the transportation means 100 to communicate with another device located in the vehicle. For example, the microphone may receive audio (for example, a voice command or another audio input) from the user of the transportation means 100. The speaker may output audio to the user of the transportation means 100. The wireless communication system may communicate wirelessly with one or more devices directly or through a communication network.

Some or all functions of the transportation means 100 are controlled by the computer system 140. The computer system 140 may control a function of the transportation means 100 based on inputs received from various systems (for example, the sensing system 120, the ADAS 110, and the peripheral device 130) and from the user interface. The computer system 140 may include at least one processor, and the processor executes instructions stored in the memory.

In this embodiment, an example in which the light source is used in a radar of a transportation means is used. In another example, the light source may alternatively be used in a fixed radar (for example, a radar fixed on a road, a surveillance radar, or a radar in an industrial scenario). The light source may alternatively be used in a radar of an uncrewed transport vehicle in a logistics warehouse, a radar of a smart appliance in a smart home (for example, the smart appliance is an automatic cleaning robot), or the like. This is not specifically limited. It may be understood that, in this embodiment, a laser beam emitted by the light source may also be referred to as an optical signal, a laser pulse, a laser, a projected light beam, an emitted beam, or the like. This is not limited. To implement differentiation, when the light source is used in different scenarios, names of light emitted by the light source are different. For example, if the light source is used in a lidar, light emitted by the light source is referred to as a laser beam. For another example, if the light source is used in an optical communication system, light emitted by the light source is referred to as an optical signal. For another example, if the light source is used in a projection system, light emitted by the light source is referred to as a projected light beam.

For example, the light source provided in this embodiment is used in a radar of a transportation means. A specific type of the radar is a lidar, and the lidar is configured to detect a to-be-detected object around the vehicle. A laser beam emitted by the light source has a high frequency and a short wavelength, so the height, distance, and speed resolution of laser detection can be improved. A detection range of the lidar is in a positive correlation with peak optical power of the laser beam output by the light source. Specifically, larger peak optical power of the laser beam emitted by the light source indicates a longer detection range of the lidar. Similarly, smaller peak optical power of the laser beam emitted by the light source indicates a shorter detection range of the lidar. For example, if the peak optical power of the laser beam emitted by the light source is 800 watts (W), the detection range of the lidar is 150 meters (m). For another example, if the peak optical power of the laser beam emitted by the light source is 1500 W, the detection range of the lidar is 220 m. For another example, if the peak optical power of the laser beam emitted by the light source is not less than 2000 W, the detection range of the lidar is 300 m. According to the light source provided in this embodiment of this application, the peak optical power output by the light source is increased when a size of the light source is effectively reduced.

The light source provided in this embodiment of this application includes a first laser and a drive circuit. The drive circuit is electrically connected to the first laser, and is configured to drive the first laser to emit light. An electrical connection in this embodiment is a circuit connection in physical contact. It may be understood that the electrical connection is a form in which the first laser and the drive circuit are connected through a physical line that can transmit an electrical signal.

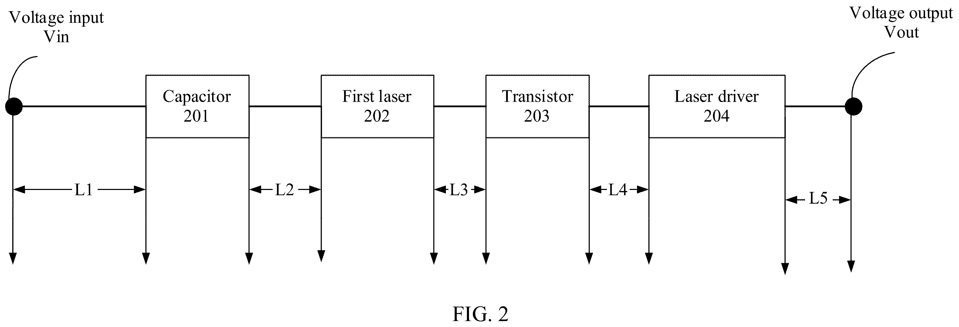

FIG. 2 is an example diagram of a circuit connection structure of an embodiment of a light source according to this application. The light source shown in this embodiment includes a first laser 202, and a drive circuit includes a capacitor 201, a transistor 203, and a laser driver (laser driver) 204. Specifically, the capacitor 201, the first laser 202, the transistor 203, and the laser driver 204 are sequentially connected in series. The capacitor 201 can output a drive current of a laser. When the transistor is in a conducted state, the laser driver 204 loads a drive current to the first laser 202, so that the first laser 202 emits an optical signal under driving of the laser driver 204. The first laser 202 may be a Fabry-Perot (Fabry-Perot, FP) laser, a distributed-feedback (distributed-feedback, DFB) laser, a vertical-cavity surface-emitting laser (vertical-cavity surface-emitting laser, VCSEL), or the like. The transistor 203 may be a bipolar transistor (bipolar transistor) (also referred to as a bipolar junction transistor). Alternatively, the transistor 203 may be a field-effect transistor (for example, a metal-oxide-semiconductor field-effect transistor (metal-oxide-semiconductor field-effect transistor, MOSFET)). This embodiment does not limit description of a structure of the drive circuit, provided that the drive circuit successfully drives the first laser to emit light. For example, the drive circuit further includes an amplification circuit configured to amplify a current loaded to the first laser 202. For another example, the drive circuit further includes an impedance matching circuit configured to implement impedance matching, and the like.

The drive current $I_{pk}$ applied by the drive circuit to the first laser 202 may be represented by using Formula 1, where Formula 1 is

$$I_{pk} = (V_{in} - V_{OUT})\sqrt{C/ESL}.$$

$V_{in}$ is a voltage at a voltage input of the drive circuit, $V_{OUT}$ is a voltage at a voltage output of the drive circuit, ESL is parasitic inductance of the drive circuit, and C is a capacitance value of the capacitor 201. It can be learned from Formula 1 that, when $V_{in}$, $V_{OUT}$, and C of the drive circuit are fixed, $I_{pk}$ is in a negative correlation with ESL. In other words, larger $I_{pk}$ indicates smaller ESL, and similarly, smaller $I_{pk}$ indicates larger ESL. Larger $I_{pk}$ indicates larger peak optical power output by the first laser 202. From the foregoing example in which the light source is used in the radar, it can be learned that larger peak optical power output by the first laser 202 indicates a longer detection range. Therefore, ESL of the drive circuit is reduced, to increase the peak optical power output by the first laser.

ESL of the drive circuit may be represented by using Formula 2, and Formula 2 is: ESL=u0*L/2$\pi$ (ln(2L/r)-0.75).

L is a physical length of an electrical connection loop between the drive circuit and the first laser, r is a cross-sectional radius of the circuit, u0 is a vacuum magnetic permeability, and u0=4$\pi$*10-7 henry per meter (H/m). It can be learned from Formula 2 that L is in a positive correlation with ESL of the drive circuit. Refer to FIG. 2. L=L1+L2+L3+L4+L5, where L1 is a physical length of a circuit between the voltage input of the drive circuit and the capacitor 201, L2 is a physical length of a circuit between the capacitor 201 and the first laser 202, L3 is a physical length of a circuit between the first laser 202 and the transistor 203, L4 is a physical length of a circuit between the transistor 203 and the laser driver 204, and L5 is a physical length of a circuit between the laser driver 204 and the voltage output of the drive circuit. When r in Formula 2 is fixed, ESL is in a positive correlation with L, that is, larger L indicates larger ESL. Similarly, smaller L indicates smaller ESL.

With reference to the negative correlation between $I_{pk}$ and ESL shown in Formula 1, and the positive correlation between ESL and L shown in Formula 2, it may be understood that, $I_{pk}$ and L are in a negative correlation. Larger $I_{pk}$ indicates larger peak optical power output by the first laser. Therefore, L may be reduced, to increase the peak optical power output by the first laser. A power supply provided in this embodiment can effectively reduce the physical length L of the electrical connection loop between the drive circuit and the first laser.

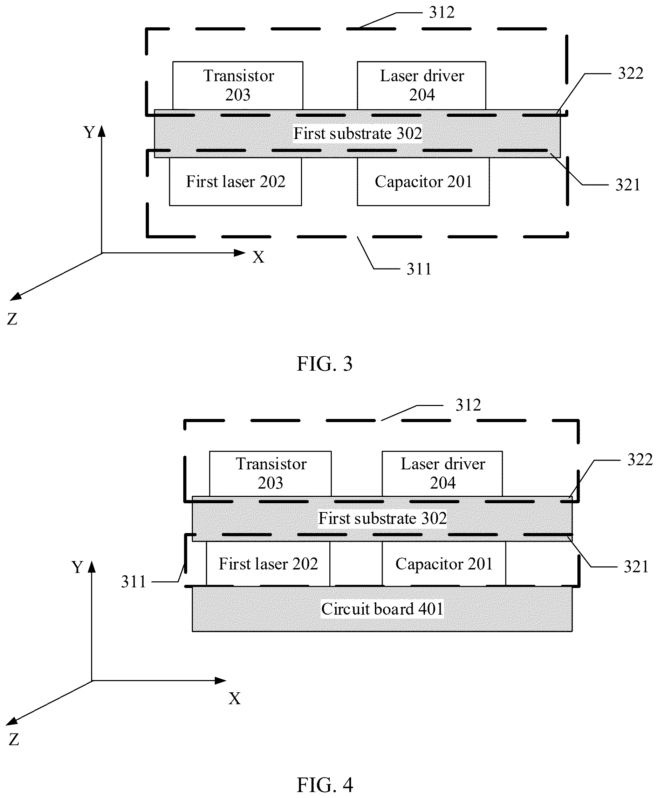

FIG. 3 is an example diagram of a packaging structure of a first embodiment of a light source according to this application. The light source shown in this embodiment includes a first substrate 302, and the first substrate 302 is made of a plate material. The plate material is not limited in this embodiment. For example, the plate material may be paper-based, fiberglass cloth-based, composite-based, ceramic-based, metal-based, epoxy glass cloth laminate (FR-4), or the like. A surface of the first substrate 302 shown in FIG. 3 is parallel to or located in an XZ plane. The XZ plane includes a direction X and a direction Z that is perpendicular to the direction X, and a direction Y is perpendicular to the XZ plane. The direction Y is a direction perpendicular to the first substrate 302. The light source includes a first packaging space 311 (shown by a dashed-line box numbered 311 in FIG. 3) and a second packaging space 312 (shown by a dashed-line box numbered 312 in FIG. 3) that are stacked in the direction Y. It may be understood that, the second packaging space 312 is located above the first packaging space 311 in the direction Y, so that the first packaging space 311 and the second packaging space 312 are stacked in the direction Y. A first surface 321 of the first substrate 302 is located in the first packaging space 311. A second surface 322 of the first substrate 302 is located in the second packaging space 312. An orientation of the first surface 321 of the first substrate 302 is opposite to an orientation of the second surface 322. It may be understood that, in the example shown in FIG. 3, the first surface 321 and the second surface 322 are two surfaces included in the first substrate 302 that are opposite in the direction Y.

FIG. 4 is an example diagram of a packaging structure of a second embodiment of a light source according to this application. The light source shown in this embodiment further includes a circuit board 401. The circuit board 401 may be a printed circuit board (printed circuit board, PCB). The first packaging space 311 is formed between the circuit board 401 and the first substrate 302. Specifically, the first packaging space 311 includes a surface that is of the circuit board 401 and that faces the first substrate 302 and the first surface 321 of the first substrate 302. The first substrate 302 and the circuit board 401 are stacked in the direction Y. The first surface 321 is a surface that is of the first substrate 302 and that faces the circuit board 401.

In the examples shown in FIG. 3 and FIG. 4, the first laser 202 is packaged in the first packaging space 311. A first drive circuit is packaged in the first packaging space 311 and the second packaging space 312. For example, the first drive circuit includes a first electrical module and a second electrical module. The first electrical module is packaged in the first packaging space 311, and the second electrical module is packaged in the second packaging space 312. This embodiment does not limit types and quantities of first electrical modules and second electrical modules. In this embodiment, the first electrical module includes the capacitor 201, and the second electrical module includes the transistor 201 and the laser driver 204. That the first drive circuit is packaged in the first packaging space 311 and the second packaging space 312 means that the capacitor 201 is packaged in the first packaging space 311, and the transistor 203 and the laser driver 204 are packaged in the second packaging space 312. To implement an electrical connection between the drive circuit and the first laser 202, the capacitor 201 and the first laser 202, the first laser 202 and the transistor 203, and the transistor 203 and the laser driver 204 are all connected in series through the first substrate 302. For circuit descriptions, refer to FIG. 2. Details are not described again.

It should be noted that the description of components packaged in the first packaging space 311 and the second packaging space 312 shown in FIG. 3 and FIG. 4 is an optional example, and is not limited. It may be understood that an example in which the light source provided in this embodiment includes four components is used, and the four components are the first laser 202, the capacitor 201, the transistor 203, and the laser driver 204. In the four components shown in this embodiment, some of the components are packaged in the first packaging space 311, and the other components are packaged in the second packaging space 312. It indicates that a packaging space in which the first laser 202 is packaged is different from a packaging space in which at least a part of the first drive circuit is packaged. Specific examples are as follows.

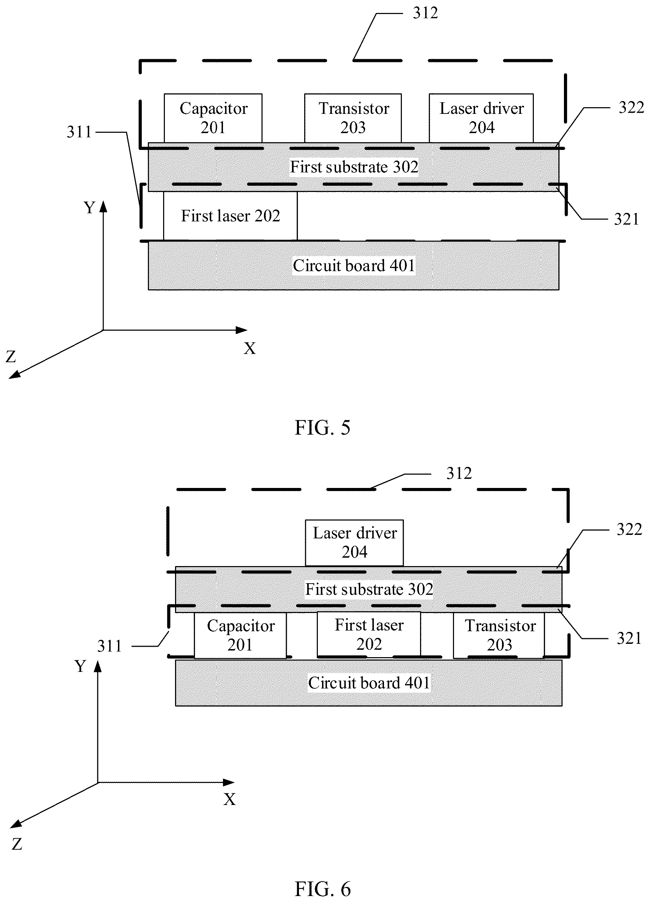

Example 1: One of the four components is packaged in the first packaging space 311 shown in this example, and the other three of the four components are packaged in the second packaging space 312. For details, refer to an example shown in FIG. 5. FIG. 5 is an example diagram of a packaging structure of a third embodiment of a light source according to this application. In the example shown in FIG. 5, the first laser 202 is packaged in the first packaging space 311, and the capacitor 201, the transistor 203, and the laser driver 204 of the drive circuit are all packaged in the second packaging space 312. It should be noted that FIG. 5 is merely an optional example of Example 1, and imposes no limitation. For example, the capacitor 201 is packaged in the first packaging space 311, and the first laser 202, the transistor 203, and the laser driver 204 are all packaged in the second packaging space 312. For another example, the transistor 203 is packaged in the first packaging space 311, and the first laser 202, the capacitor 201, and the laser driver 204 are all packaged in the second packaging space 312. For another example, the laser driver 204 is packaged in the first packaging space 311, and the first laser 202, the capacitor 201, and the transistor 203 are all packaged in the second packaging space 312.

Example 2: Two of the four components are packaged in the first packaging space 311 shown in this example, and the other two of the four components are packaged in the second packaging space 312. For details, refer to the examples shown in FIG. 3 and FIG. 4. FIG. 3 and FIG. 4 are merely an optional example, and impose no limitation. For example, the first laser 202 and the transistor 203 are packaged in the first packaging space 311, and the capacitor 201 and the laser driver 204 are packaged in the second packaging space 312. For another example, the first laser 202 and the laser driver 204 are packaged in the first packaging space 311, and the capacitor 201 and the transistor 203 are packaged in the second packaging space 312. For another example, the capacitor 201 and the transistor 203 are packaged in the first packaging space 311, and the first laser 202 and the laser driver 204 are packaged in the second packaging space 312. For another example, the capacitor 201 and the laser driver 204 are packaged in the first packaging space 311, and the transistor 203 and the first laser 202 are packaged in the second packaging space 312. For another example, the transistor 203 and the laser driver 204 are packaged in the first packaging space 311, and the first laser 202 and the capacitor 201 are packaged in the second packaging space 312.

Example 3: Three of the four components are packaged in the first packaging space 311 shown in this example, and the other one of the four components is packaged in the second packaging space 312. For details, refer to an example shown in FIG. 6. FIG. 6 is an example diagram of a packaging structure of a fourth embodiment of a light source according to this application. In the example shown in FIG. 6, the first laser 202, the capacitor 201, and the transistor 203 are packaged in the first packaging space 311. The laser driver 204 is packaged in the second packaging space 312. It should be noted that FIG. 6 is merely an optional example of Example 3, and imposes no limitation. For example, the capacitor 201, the laser driver 204, and the first laser 202 are packaged in the first packaging space 311, and the transistor 203 is packaged in the second packaging space 312. For another example, the laser driver 204, the first laser 202, and the first laser 202 are packaged in the first packaging space 311, and the capacitor 201 is packaged in the second packaging space 312. For another example, the laser driver 204, the transistor 203, and the capacitor 201 are packaged in the first packaging space 311, and the first laser 202 is packaged in the second packaging space 312.

In the foregoing three examples, two or more components packaged in a same packaging space may be integrated into a system in a package (system in a package, SIP). For example, in the example shown in FIG. 3, the transistor 203 and the laser driver 204 are integrated into one package, to be packaged in the second packaging space 312 in a SIP manner. Optionally, the first substrate 302 may be packaged in the SIP, so that the SIP integrates the first substrate 302, the transistor 203, and the laser driver 204, to improve integration of the light source.

In this embodiment, the first packaging space and the second packaging space are stacked in the direction Y, and the component packaged in the first packaging space and the component packaged in the second packaging space (refer to the foregoing Example 1 to Example 3) are directly electrically connected through the first substrate 302, to effectively reduce a physical length of an electrical connection loop between the component packaged in the first packaging space and the component packaged in the second packaging space. For example, the first laser is packaged in the first packaging space, the transistor is packaged in the second packaging space, and the first laser and the transistor are directly electrically connected in the Y direction through the first substrate 302, to effectively reduce a physical length of an electrical connection loop between the first laser and the transistor. It may be understood that, when the first laser and the drive circuit are packaged in the first packaging space and the second packaging space, a physical length of an electrical connection loop between the drive circuit and the first laser is effectively reduced. Because the physical length of the electrical connection loop between the drive circuit and the first laser is in a negative correlation with the drive current $I_{pk}$, the drive current $I_{pk}$ is effectively increased when, according to the light source in this embodiment, the physical length of the electrical connection loop between the drive circuit and the first laser is reduced. When the drive current $I_{pk}$ in the light source is increased, the peak optical power output by the first laser is effectively increased.

The first laser and the drive circuit shown in this embodiment are packaged in the first packaging space and the second packaging space in a manner of being stacked, to ensure that the drive circuit successfully drives the first laser to emit light, and increase peak optical power of the laser when the physical length of the electrical connection loop between the drive circuit and the first laser is reduced.

In an existing solution, if peak optical power output by a light source needs to be increased, more lasers need to be integrated into the light source. However, according to the light source shown in this application, peak optical power output by each laser is effectively increased. In this case, if the light source in the existing solution and the light source provided in this embodiment of this application output same peak optical power, the light source provided in this embodiment of this application includes fewer lasers, so that a size of the heat sink does not need to be increased, to effectively reduce a size of the light source, improve integration and size utilization of the light source, and reduce costs of the light source. Compared with that of the existing light source, the drive current of the light source provided in this embodiment of this application is increased by approximately 75%, so that output peak optical power is increased by approximately 50%.

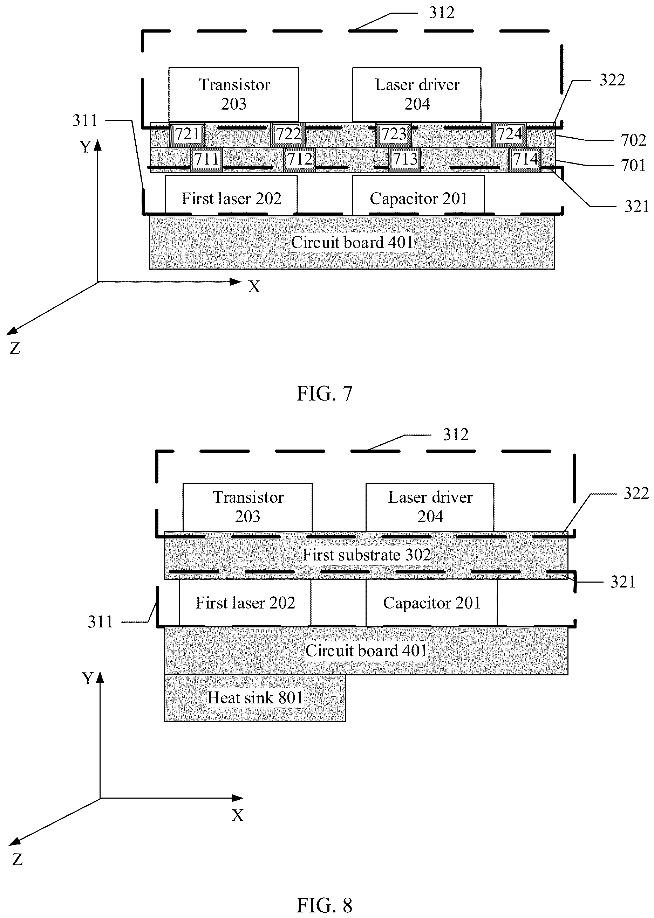

With reference to FIG. 7, a description in which the drive circuit is electrically connected to the first laser through the first substrate is described. FIG. 7 is an example diagram of a packaging structure of a fifth embodiment of a light source according to this application.

In the example shown in FIG. 7, an example in which the first laser 202 and the capacitor 201 are packaged in the first packaging space 311, and the transistor 203 and the laser driver 204 are packaged in the second packaging space 312 is used for description. In a direction (namely, the direction Y) perpendicular to the first substrate, the first substrate includes at least a first sub-substrate 701 and a second sub-substrate 702 that are stacked. A distance between the first sub-substrate 701 and the circuit board 401 is less than a distance between the second sub-substrate 702 and the circuit board 401 in the direction Y. The first sub-substrate 701 includes a plurality of first current channels. A quantity of first current channels included in the first sub-substrate 701 is not limited in this embodiment. For example, in the example shown in FIG. 7, the first sub-substrate 701 includes a first current channel 711, a first current channel 712, a first current channel 713, and a first current channel 714. Each first current channel included in the first sub-substrate 701 passes through the first sub-substrate 701 in the direction Y. The second sub-substrate 702 includes a plurality of second current channels. A quantity of second current channels included in the second sub-substrate 702 is not limited in this embodiment. For example, in the example shown in FIG. 7, the second sub-substrate 702 includes a second current channel 721, a second current channel 722, a second current channel 723, and a second current channel 724. Each second current channel included in the second sub-substrate 702 passes through the second sub-substrate 702 in the direction Y. The first current channel 711 is used as an example. The first current channel 711 is a conductive material that penetrates the first sub-substrate 701, and the conductive material is not limited in this embodiment, for example, may be silver, copper, gold, aluminum, or nickel. For descriptions of the second current channel, refer to the descriptions of the first current channel 711. Details are not described again.

In this embodiment, the first current channel and the second current channel that are close to each other are in contact with each other, to implement an electrical connection. For example, the first current channel 711 and the second current channel 721 are in contact with each other, to implement an electrical connection, and by analogy, the first current channel 714 and the second current channel 724 are in contact with each other, to implement an electrical connection. The first laser 202 and each component included in the drive circuit are welded to the first substrate 302 through flip-chip bonding. The first laser 202 is used as an example. That the first laser 202 is welded to the first substrate 302 through flip-chip bonding means that an electrical connecting member of the first laser 202 faces the first substrate 302. The electrical connecting member may be a solder ball. The solder ball of the first laser 202 is welded to the first current channel of the first sub-substrate 701, to implement an electrical connection between the first laser 202 and the first substrate 302. The transistor 203 is welded to the second current channel of the second sub-substrate 702 through flip-chip bonding. The first current channel is electrically connected to the second current channel, so that an electrical connection between the first laser 202 and the transistor 203 is implemented through the first substrate 302, and a physical length of an electrical connection loop between the first laser 202 and the transistor 203 is reduced through the first substrate 302. In this embodiment, an example in which each component is packaged in the first packaging space or the second packaging space through flip-chip bonding is used. This is not specifically limited. In another example, the component may be packaged in the first packaging space or the second packaging space in any manner of die bonding (die bonding).

Between the plurality of first current channels and the plurality of second current channels shown in this embodiment, the first current channel 711 is close to the second current channel 721. In this case, a first orthographic projection of the first current channel 711 partially overlaps with a second orthographic projection of the second current channel 721. The first orthographic projection of the first current channel 711 is an orthographic projection formed on a projection surface by a plurality of mutually parallel projection lines irradiating the first current channel 711. The first sub-substrate 701 is parallel to the projection surface, and the plurality of projection lines are perpendicular to the projection surface and the first sub-substrate 701. For descriptions of the second orthographic projection of the second current channel 721, refer to the descriptions of the first orthographic projection of the first current channel 711. Details are not described again. It may be understood that, in this embodiment, a first orthographic projection of any one of the plurality of first current channels partially overlaps with an orthographic projection of one of the plurality of second current channels.

For descriptions of beneficial effects of the first current channel 711 and the second current channel 721 being in contact with each other to implement an electrical connection in this embodiment, refer to Formula 3.

Formula 3 is:

$$ ESL = A * h * (In \frac{4h}{D} + 1) $$

In is a logarithm whose base is e, and A is a preset constant. For example, A=5.08. h is a sum of through via depths of current channels that are located on different sub-substrates and that are in contact with each other to implement an electrical connection. For example, h is a sum of a depth of the first current channel 711 in the direction Y and a depth of the second current channel 721 in the direction Y. D is a sum of through via diameters of current channels that are located on different sub-substrates and that are in contact with each other to implement an electrical connection. For example, D is a sum of a diameter of the first current channel 711 and a diameter of the second current channel 721. Refer to FIG. 7. The current channels of the different sub-substrates are arranged in a staggered manner, so that a diameter of a current channel of the substrate is equivalent to be increased. For example, a diameter of one current channel of the substrate is a sum of the diameter of the first current channel 711 and the diameter of the second current channel 721. This improves inductance of the drive circuit.

With reference to the negative correlation between $I_{pk}$ and ESL shown in Formula 1, and a negative correlation between D and ESL shown in Formula 3, it may be understood that, $I_{pk}$ and D are in a positive correlation. Therefore, a manner of increasing D can effectively increase $I_{pk}$ of the drive circuit. In this embodiment, the current channels of the different sub-substrates are arranged in a staggered manner, to effectively increase the diameter D of the current channel of the substrate. This effectively improves $I_{pk}$ of the drive circuit.

In this embodiment, an example in which the first substrate 302 includes two sub-substrates is used. In another example, the first substrate 302 may include more than two sub-substrates. A quantity of sub-substrates included in the first substrate 302 is not limited in this embodiment. The first substrate 302 shown in this embodiment includes a plurality of layers of sub-substrates, each sub-substrate includes a plurality of current channels, and the first orthographic projection and the second orthographic projection of different layers partially overlap, to improve uniformity of a current flowing through the first substrate. This effectively reduces parasitic inductance of the drive circuit. For example, compared with an existing manner in which a laser and a drive circuit in a light source are connected in series, according to the light source shown in this embodiment of this application, parasitic inductance of the light source is reduced by approximately 30%.

It should be noted that, the circuit board 401 shown in this embodiment may alternatively be of a structure of the first substrate. In other words, the circuit board 401 includes the first sub-substrate and the second sub-substrate, the first sub-substrate includes a plurality of first current channels, and the second sub-substrate includes a plurality of second current channels. For descriptions of the first sub-substrate, the second sub-substrate, the first current channel, and the second current channel that are included in the circuit board 401, refer to descriptions of the first substrate structure corresponding to FIG. 7. Details are not described again.

FIG. 8 is an example diagram of a packaging structure of a sixth embodiment of a light source according to this application. The light source shown in this embodiment further includes a heat sink 801. Specifically, the heat sink 801 is packaged on a surface that is of the circuit board 401 and that faces away from the first substrate 302. The heat sink 801 is configured to control optical power of an optical signal emitted by the first laser 202 to be within a preset range, to ensure stability of the peak optical power output by the first laser 202, and avoid a case in which the peak optical power output by the first laser 202 decreases. A specific heat dissipation manner of the heat sink 801 is not limited in this embodiment. For example, the heat sink 801 includes an air cooling system, a water cooling system, a thermoelectric cooler (thermoelectric cooler, TEC), a heat sink fin, an electric cooler, or the like.

The light source shown in this embodiment includes a first laser array, and the first laser array includes N*M first lasers. For descriptions of the first laser, refer to the foregoing embodiments. Details are not described again. N is a quantity of first lasers included in the first laser in the direction X, and M is a quantity of first lasers included in the first laser array in the direction Z. For descriptions of a packaging position of the first laser array in the light source in this embodiment, refer to the description of a packaging position of the first laser 202. Details are not described again. A specific electrical connection form of the first laser array is not limited in this embodiment. For example, in the first laser array, different first lasers are connected in parallel, so that each first laser is connected in series to the drive circuit. For another example, in the first laser array, some first lasers are sequentially connected in series, and are connected in series to the drive circuit. The other first lasers are connected in parallel and connected in series to the drive circuit. For another example, in the first laser array, the plurality of first lasers are sequentially connected in series, and are connected in series to the drive circuit.

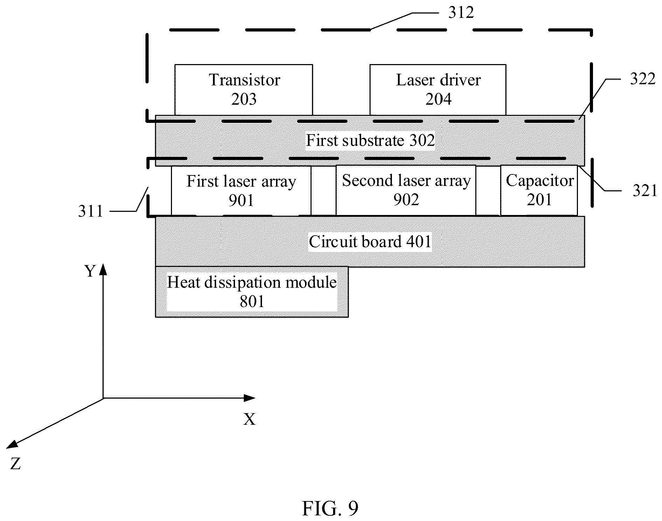

FIG. 9 is an example diagram of a packaging structure of a seventh embodiment of a light source according to this application. The light source shown in this embodiment includes the first laser array 901 and a second laser array 902. The second laser array 902 includes a plurality of second lasers. For descriptions of the plurality of second lasers included in the second laser array 902, refer to the foregoing descriptions of the plurality of first lasers included in the first laser array. Details are not described again. In the embodiment shown in FIG. 9, an example in which the first laser array 901 and the second laser array 902 are packaged in the first packaging space is used. The first laser array 901 and the second laser array 902 are connected in parallel, and the first laser array 901 and the second laser array 902 each are connected in series to the drive circuit. For descriptions in which the drive circuit is packaged in the light source, refer to the foregoing example. This is not limited. An electrical connection manner between the first laser array 901 and the second laser array 902 is not limited in this embodiment. In another example, some second lasers included in the second laser array 902 are connected in series to the first laser array 901, and the other second lasers are connected in parallel to the first laser array 901. For another example, the second laser array 902 is connected in series to the first laser array 901. In this embodiment, an example in which both the first laser array 901 and the second laser array 902 are packaged in the first packaging space 311 is used, and this is not limited. In another example, both the first laser array 901 and the second laser array 902 are packaged in the second packaging space 312. For another example, the first laser array 901 is packaged in the first packaging space 311, and the second laser array 902 is packaged in the second packaging space 312. For another example, the first laser array 901 is packaged in the second packaging space 312, and the second laser array 902 is packaged in the first packaging space 311. A quantity of laser arrays included in the light source is not limited in this embodiment. When the light source includes a plurality of laser arrays, the peak optical power output by the light source is increased.

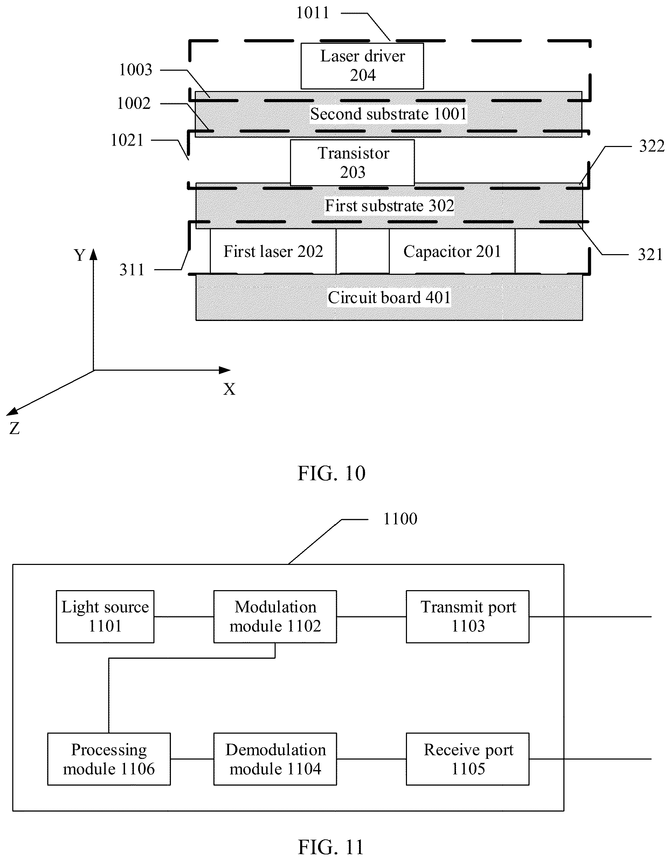

FIG. 10 is an example diagram of a packaging structure of an eighth embodiment of a light source according to this application. The light source shown in this embodiment further includes a second substrate 1001 in the direction Y perpendicular to the first substrate 302. It may be understood that, the first substrate 302 and the second substrate 1001 are stacked in the direction Y perpendicular to the first substrate 302. The second packaging space shown in this embodiment specifically includes a first packaging subspace 1021 and a second packaging subspace 1011. Specifically, a third surface 1002 of the second substrate 1001 and the second surface 322 of the first substrate 302 are located in the second packaging subspace 1021. It may be understood that the third surface 1002 of the second substrate 1001 is a surface that is of the second substrate 1001 and faces the first substrate 302. In other words, the second substrate 1001, the first substrate 302, and the circuit board 401 are sequentially stacked in the direction Y. In the direction perpendicular to the first substrate 302 (namely, in the direction Y), the light source includes the second packaging subspace 1011 (as shown by a dashed-line box numbered 1011 shown in FIG. 10) that is stacked with the first packaging space and the second packaging space. A fourth surface 1003 of the second substrate 1001 is located in the second packaging subspace 1011. An orientation of the third surface 1002 is opposite to an orientation of the fourth surface 1003. For descriptions of positions of the third surface 1002 and the fourth surface 1003 of the second substrate 1001, refer to the descriptions of positions of the first surface 321 and the second surface 322 of the first substrate 302 in the foregoing embodiments. Details are not described again. The drive circuit and the first laser shown in this embodiment are packaged in the first packaging space, the first packaging subspace 1021, and the second packaging subspace 1011. For example, the first laser 202 and the capacitor 201 are packaged in the first packaging space 311, the transistor 203 is packaged in the second packaging subspace 1021, and the laser driver 204 is packaged in the second packaging subspace 1011. It may be understood that the first laser and the drive circuit in this embodiment include four components. At least one of the four components is packaged in each of the first packaging space 311, the second packaging subspace 1021, and the second packaging subspace 1011. For specific descriptions, refer to descriptions in which the four components are packaged in the first packaging space 311 and the second packaging space 312 shown in Example 1 to Example 3. Details are not described again. The light source shown in this embodiment may further include the first laser array and the second laser array. For descriptions of the first laser array and the second laser array, refer to the descriptions corresponding to FIG. 9. Details are not described again. The first laser array and the second laser array may be packaged in a same packaging space in the first packaging space 311, the second packaging subspace 1021, and the second packaging subspace 1011. For another example, the first laser array and the second laser array may be packaged in any two different packaging spaces in the first packaging space 311, the second packaging subspace 1021, and the second packaging subspace 1011. It should be noted that, for descriptions of a structure of the second substrate 1001 and descriptions of implementation of an electrical connection of the second substrate 1001, refer to the descriptions of the structure of the first substrate 302 and the descriptions of implementation of the electrical connection of the first substrate 302 in the foregoing embodiments. Details are not described again. A quantity of substrates included in the light source is not limited in this embodiment. In another example, the light source may include any quantity of more than two substrates.

FIG. 11 is an example diagram of a structure of an embodiment of a photoelectric conversion apparatus according to this application. The photoelectric conversion apparatus 1100 shown in this embodiment may be referred to as an optical module (optical transceiver). The photoelectric conversion apparatus 1100 includes a light source 1101, a modulation module 1102, a demodulation module 1104, a transmit (transport, TX) port 1103, a receive (receive, RX) port 1105, and a processing module 1106. The processing module 1106 is connected to the modulation module 1102 and the demodulation module 1104, the modulation module 1102 is connected to the light source 1101 and the transmit port 1103, and the demodulation module 1104 is connected to the receive port 1105. The light source 1101 is configured to send an optical signal to the modulation module 1102. The processing module 1106 is configured to send a first service electrical signal to the modulation module 1102. The modulation module 1102 is configured to receive the optical signal from the light source, and is configured to modulate the first service electrical signal onto the optical signal to obtain a first service optical signal. The light source 1101 and the modulation module 1102 shown in this embodiment may be two discrete components, or the light source 1101 and the modulation module 1102 may be packaged into an integrated component, to perform photoelectric conversion on the first service electrical signal to output the first service optical signal. This is not specifically limited in this embodiment. The transmit port 1103 is configured to emit the first service optical signal from the modulation module 1102.

The receive port 1105 is configured to receive a second service optical signal, and the demodulation module 1104 is configured to receive the second service optical signal from the receive port 1105, and is configured to perform photoelectric conversion on the second service optical signal to demodulate the second service optical signal into a second service electrical signal. The demodulation module 1104 is configured to send the second service electrical signal to the processing module 1106.

A form of the processing module 1106 is not limited in this embodiment. For example, the processing module 1106 may be one or more chips or one or more integrated circuits. For example, the processing module 1106 may be one or more optical digital signal processors (optical digital signal processors, ODSPs), field programmable gate arrays (field programmable gate arrays, FPGAs), application-specific integrated circuits (application-specific integrated circuits, ASICs), systems on chip (systems on chip, SoCs), central processing units (central processing units, CPUs), network processors (network processors, NPs), microcontroller units (microcontroller units, MCUs), programmable logic devices (programmable logic devices, PLDs), or other integrated chips, or any combination of the foregoing chips or processing modules. Details are not described herein.

The photoelectric conversion apparatus in this embodiment includes an optical fiber connector, and the optical fiber connector includes the transmit port 1103 and the receive port 1105. The transmit port 1103 is configured to connect a first external optical cable and a first internal optical cable. The receive port 1105 is configured to connect a second external optical cable and a second internal optical cable. The first external optical cable and the second external optical cable are located outside a housing of the photoelectric conversion apparatus 1100. The first internal optical cable and the second internal optical cable are located inside the housing of the photoelectric conversion apparatus 1100. For example, if the photoelectric conversion apparatus 1100 is connected to an external device, one end of the first external optical cable is connected to the transmit port 1103, and the other end is connected to the external device, so that the photoelectric conversion apparatus 1100 sends the first service optical signal to the external device through the first external optical cable. For another example, one end of the second external optical cable is connected to the receive port 1105, and the other end is connected to the external device, so that the photoelectric conversion apparatus 1100 receives the second service optical signal from the external device through the second external optical cable. The transmit port 1103 is connected to the modulation module 1102 through the first internal optical cable. The receive port 1105 is connected to the demodulation module 1104 through the second internal optical cable.

A specific type of the optical fiber connector shown in this embodiment may be any one of the following types. It should be noted that the description of a type of the optical fiber connector in this embodiment is an optional example, and is not limited.

Multi-fiber push on (multi-fiber push on, MPO) connector, ferrule connector (ferrule connector, FC), square connector (square connector, SC), lucent connector (lucent connector, LC), straight tip (straight tip, ST) connector, or fiber-distributed data interface (fiber-distributed data interface, IFDD) connector.

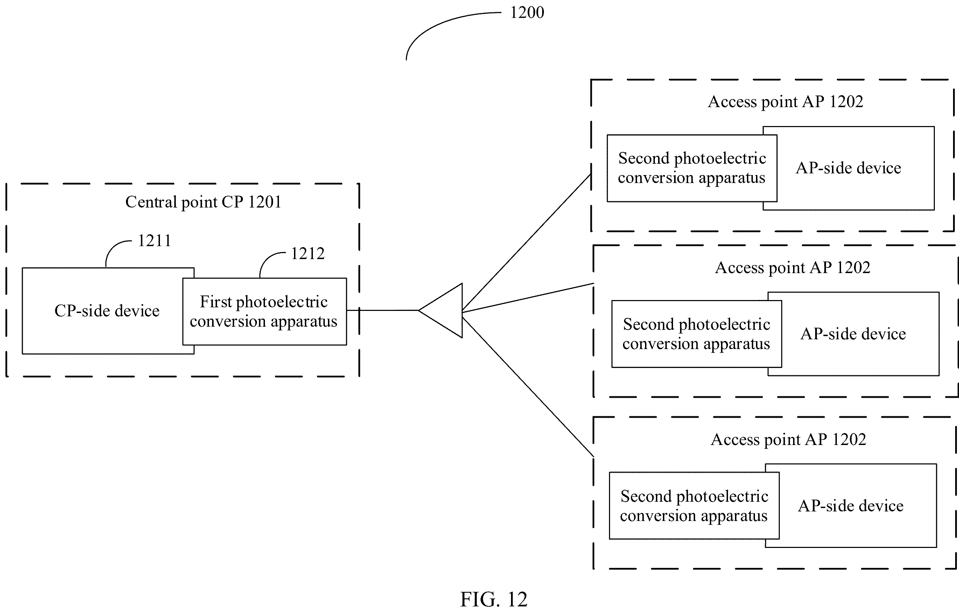

FIG. 12 is an example diagram of a structure of an embodiment of an optical communication system according to this application. The optical communication system 1200 shown in this embodiment includes a central point (central point, CP) 1201 and a plurality of access points (access points, APs) 1202 connected to the CP 1201. The CP 1201 may be connected to the plurality of APs through one or more optical splitters. A quantity of APs included in the optical communication system 1200 is not limited in this embodiment. For example, the optical communication system 1200 includes three APs 1202. The CP 1201 includes an outer housing, a subrack, a CP-side device 1211, and a first photoelectric conversion apparatus 1212. The CP-side device 1211 includes a processor. For descriptions of a type of the processor, refer to the descriptions of the processing module corresponding to FIG. 11. Details are not described again. The processor is configured to send a first service electrical signal to the first photoelectric conversion apparatus 1212, and is configured to receive a second service electrical signal from the first photoelectric conversion apparatus 1212. The subrack of the CP-side device 1211 is configured to be inserted with one or more first photoelectric conversion apparatuses 1212. Optionally, the first photoelectric conversion apparatus 1212 may alternatively be integrated with the CP-side device 1211. For descriptions of the first photoelectric conversion apparatus 1212, refer to the descriptions corresponding to FIG. 11. Details are not described again. The CP 1201 is connected to the AP 1202 through an external optical cable.

The AP 1202 includes an outer housing, a second photoelectric conversion apparatus, and an AP-side device. For example, the second photoelectric conversion apparatus may be directly inserted into the AP-side device, or may be integrated with the AP-side device. In this embodiment, an example in which the AP 1202 includes one second photoelectric conversion apparatus is used. In another example, the AP 1202 may alternatively include a plurality of second photoelectric conversion apparatuses. For descriptions of a structure of the AP 1202 in this embodiment, refer to the descriptions of the structure of the CP 1201. Details are not described again.

This embodiment does not limit a network in which the optical communication system 1200 is used. For example, if the optical communication system 1200 shown in this embodiment is used in a PON, the AP may be an optical network unit (optical network unit, ONU) or an optical network terminal (optical network terminal, ONT). The central point CP 1201 may be an optical line terminal (optical line terminal, OLT), a switch (for example, a core layer switch or a layer 2 switch), a router, or the like. If the optical communication system 1200 is used in an OTN, both the CP and the AP may be OTN devices.

An embodiment of this application provides an optical communication device. For descriptions of the optical communication device, refer to the descriptions of the CP 1201 or the AP 1202 corresponding to FIG. 12. Details are not described again.

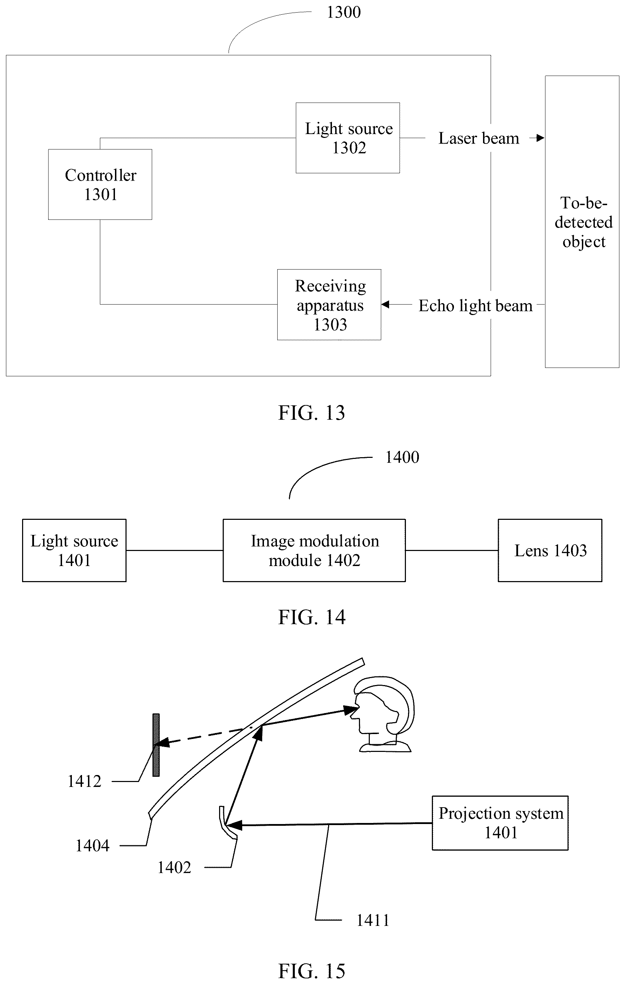

FIG. 13 is an example diagram of a structure of an embodiment of a radar according to this application. The radar 1300 shown in this embodiment includes a controller 1301, a light source 1302, and a receiving apparatus 1303. Each of the light source 1302 and the receiving apparatus 1303 is connected to the controller 1301. A connection relationship between components included in the radar may be an electrical connection, or may be an optical fiber connection. The controller 1301 is configured to control the light source 1302 and the receiving apparatus 1303, so that the light source 1302 and the receiving apparatus 1303 operate normally. For example, the controller 1301 provides a drive voltage for each of the light source 1302 and the receiving apparatus 1303, and the controller 1301 may further provide an emission control signal for the light source 1302. For descriptions of a structure of the light source 1302, refer to the descriptions in the foregoing embodiments. Details are not described again. For descriptions of a type of the controller 1301, refer to the descriptions of the processing module type corresponding to FIG. 11. Details are not described again.

The controller 1301 is configured to send a control signal to the light source 1302, and the light source 1302 is configured to emit, based on the control signal, a laser beam used to implement radar detection. The laser beam propagates in a direction of emission. After the laser beam meets a to-be-detected object, the laser beam is reflected on a surface of the to-be-detected object, and a reflected echo light beam is received by the receiving apparatus 1303 of the radar 1300. In this embodiment of this application, the light beam that is of the laser beam and that is reflected back by the to-be-detected object is referred to as the echo light beam. After receiving the echo light beam, the receiving apparatus 1303 performs photoelectric conversion on the echo light beam, that is, converts the echo light beam into an electrical signal (the electrical signal is referred to as a detection electrical signal below). The receiving apparatus 1303 sends the detection electrical signal to the controller 1301, so that the controller 1301 can obtain location information of the to-be-detected object based on the detection electrical signal. Specifically, the controller 1301 may calculate a time delay between an emission time point of the laser beam and a return time point of the detection electrical signal, to determine the location information of the to-be-detected object. In addition, the radar 1300 may further emit laser beams with different spatial orientations to the to-be-detected object, to obtain location information of points on a surface of the to-be-detected object, and generate a point cloud image of the to-be-detected object.

In this embodiment, an example in which the radar 1300 is a lidar is used, and the lidar is a target detection technology. The lidar emits a laser beam, and diffuse reflection occurs after the laser beam meets the to-be-detected object, and characteristic quantities such as a distance, an orientation, a height, a speed, a posture, and a shape of the to-be-detected object are determined based on a reflected echo light beam. Lidars are used in fields such as intelligent driving vehicles, intelligent driving aircrafts, 3D printing, virtual reality (virtual reality, VR), augmented reality (augmented reality, AR), and service robots. Intelligent driving in this embodiment of this application may be self driving, autonomous driving, assisted driving, or the like.

FIG. 14 is an example diagram of a structure of an embodiment of a projection system according to this application. The projection system 1400 includes a light source 1401, an image modulation module 1402, and a lens 1403. For descriptions of a structure of the light source 1401 shown in this embodiment, refer to the foregoing embodiments. Details are not described again. The light source 1401 in this embodiment outputs a projected light beam (white light) to the image modulation module 1402. The image modulation module 1402 is configured to receive the projected light beam from the light source 1401, is configured to modulate the projected light beam 1401 to obtain a modulated light beam, and is further configured to transmit the modulated light beam to the lens 1403. The lens 1403 is configured to project the modulated light beam outward, and is configured to perform imaging on the modulated light beam. The lens 1403 may be a short-focus lens.

The image modulation module 1402 in this embodiment may be a liquid crystal on silicon (liquid crystal on silicon, LCOS) display, an organic light emitting diode (organic light-emitting diode, OLED) display, a liquid crystal display (liquid crystal display, LCD), a digital light processing (digital light processing, DLP) display, a micro-electro-mechanical system (micro-electro-mechanical system, MEMS) display, or the like.

The light source 1401 in this embodiment may include a tri-color light source (a laser array included in the light source specifically includes a laser configured to emit blue light, a laser configured to emit red light, and a laser configured to emit green light). Optionally, the light source 1401 may include an optical splitting member, and the optical splitting member may be a wave plate, a semi-reflective and semi-transparent wave plate, or the like. The optical splitting member is configured to filter out red light from the projected light beam output by the light source and transmit the red light to the image modulation module 1402. The optical splitting member is configured to filter out blue light from the projected light beam output by the light source and transmit the blue light to the image modulation module 1402. The optical splitting member is configured to filter out green light from the projected light beam output by the light source and transmit the green light to the image modulation module 1402.

The projection system shown in this embodiment may be used in a projector headlight.

Specifically, the modulated light beam emitted by the lens 1403 displays a target light pattern on a road surface for imaging. The target light pattern formed by the modulated light beam may be a light carpet displayed in a projection area on the road surface. The light carpet notifies a driver of ADAS information of a vehicle, main data (fuel consumption, engine rotation speed, temperature, and the like) on a vehicle dashboard, vehicle speed information, steering wheel angle information, vehicle body posture data, or the like based on a modulated image, color, light pattern, or the like. This is not specifically limited in this embodiment. The modulated light beam that is emitted by the projector headlight in this embodiment and that is displayed in the target light pattern may further be used to illuminate a road surface around the vehicle, or the like, to improve driving safety or navigation efficiency. The projector headlight shown in this embodiment is used for vehicle lighting and image projection, and may be a low beam or an adaptive high beam, to implement assisted autonomous driving of the vehicle.

FIG. 15 is an example diagram of a structure of an embodiment of a head-up display system according to this application. The head-up display (head-up display, HUD) system shown in this embodiment includes a projection system 1401 and an optical deflection module 1402. For descriptions of the projection system 1401, refer to the descriptions corresponding to FIG. 13. Details are not described again. The HUD system projects vehicle-related information in front of a field of view of the driver. The vehicle-related information may be meter information (for example, a vehicle speed) or navigation information. In this case, the driver can see the vehicle-related information in front of the field of view without having to look down at the dashboard or a central display screen under a steering wheel, to improve a braking response time in an emergency and improve driving safety.

The projection system 1401 in this embodiment transmits a modulated light beam 1411 to the optical deflection module 1402. Specifically, as shown in FIG. 13, the projection system 1401 includes the light source, the image modulation module, and the lens. The light source transmits a projected light beam to the image modulation module, and the image modulation module modulates the vehicle-related information on the projected light beam to obtain the modulated light beam 1411. The lens 1403 transmits imaged modulated light beam 1411 to the optical deflection module 1402. The optical deflection module 1402 forms an amplified virtual image 1412 of the modulated light beam in front of the vehicle. The optical deflection module in this embodiment includes a curved mirror 1403. The curved mirror 1403 amplifies a light spot of the modulated light beam 1411 for transmission to a windshield 1404 of the vehicle. The windshield 1404 reflects the modulated light beam 1411 to eyes of the driver for imaging. In other words, a reverse extension line of an image formed in the eyes of the driver forms the virtual image 1412 in front of the vehicle. In this embodiment, an example in which the HUD system is used in the vehicle is used. In another example, the HUD system may alternatively be used in a driving tool that needs to be driven by a driver, such as a ship, an aircraft, or a helicopter.

The HUD shown in this embodiment may alternatively be a HUD having a three-dimensional (three-dimensional, 3D) display function. The HUD having the 3D display function modulates vehicle driving related information on a projected light beam emitted by a projection system, and displays the vehicle driving related information in front of a vehicle in a form of a virtual image. In addition, the virtual image is superimposed with a road condition scenario (such as a road, a building, or a pedestrian), to achieve 3D display effect.

This embodiment further provides a transportation means. For descriptions of a specific structure, refer to the descriptions corresponding to FIG. 1. Details are not described again.

The foregoing embodiments are merely intended to describe the technical solutions of this application, but are not intended to limit this application. Although this application is described in detail with reference to the foregoing embodiments, a person of ordinary skill in the art should understand that the technical solutions described in the foregoing embodiments may still be modified or some technical features thereof may be equivalently replaced. These modifications or replacements do not enable essence of a corresponding technical solution to depart from the spirit and scope of the technical solutions of embodiments of this application.

**Claims**

1. A light source, comprising a first substrate, a drive circuit, and a first laser, wherein the drive circuit is electrically connected to the first laser through the first substrate, and the drive circuit is configured to drive the first laser to emit light;

   the light source comprises a first packaging space and a second packaging space that are stacked in a direction perpendicular to the first substrate, a first surface of the first substrate is located in the first packaging space, a second surface of the first substrate is located in the second packaging space, and an orientation of the first surface is opposite to an orientation of the second surface; and
   the first laser is packaged in the first packaging space or the second packaging space, the drive circuit is packaged in at least one of the first packaging space and the second packaging space, and a packaging space in which the first laser is packaged is different from a packaging space in which at least a part of the drive circuit is packaged.

2. The light source according to claim 1, wherein in the direction perpendicular to the first substrate, the light source further comprises a circuit board stacked with the first substrate, a surface that is of the circuit board and that faces the first substrate is located in the first packaging space, and the first surface is a surface that is of the first substrate and that faces the circuit board.

3. The light source according to claim 1 or 2, wherein in the direction perpendicular to the first substrate, the first substrate comprises at least a first sub-substrate and a second sub-substrate that are stacked, the first sub-substrate comprises a first current channel passing through the first sub-substrate, the second sub-substrate comprises a second current channel passing through the second sub-substrate, any one of a plurality of first current channels is electrically connected to one of a plurality of second current channels, and the drive circuit is electrically connected to the first laser through the first current channel and the second current channel.

4. The light source according to claim 3, wherein a first orthographic projection partially overlaps with a second orthographic projection, the first orthographic projection is an orthographic projection of the any one of the plurality of first current channels, and the second orthographic projection is an orthographic projection of the one of the plurality of second current channels.

5. The light source according to any one of claims 1 to 4, wherein the drive circuit comprises a first electrical module and a second electrical module, the first electrical module is packaged in the first packaging space, and the second electrical module is packaged in the second packaging space.

6. The light source according to any one of claims 1 to 4, wherein the first laser is packaged in the first packaging space, and the drive circuit is packaged in the second packaging space; or the first laser is packaged in the second packaging space, and the drive circuit is packaged in the first packaging space.

7. The light source according to any one of claims 1 to 6, wherein the light source further comprises a second laser electrically connected to the drive circuit, the drive circuit is electrically connected to the second laser through the first substrate, and the drive circuit is further configured to drive the second laser to emit light; and
the second laser is packaged in the first packaging space or the second packaging space.

8. The light source according to any one of claims 1 to 7, wherein in the direction perpendicular to the first substrate, the light source further comprises a second substrate stacked with the first substrate, the second packaging space comprises a first packaging subspace and a second packaging subspace, a third surface of the second substrate and the second surface are located in the first packaging subspace, the third surface is a surface that is of the second substrate and that faces the first substrate, a fourth surface of the second substrate is located in the second packaging subspace, and an orientation of the third surface is opposite to an orientation of the fourth surface; and
the first laser is packaged in one of the first packaging space, the first packaging subspace, and the second packaging subspace, and the drive circuit is packaged in at least one of the first packaging space, the first packaging subspace, and the second packaging subspace.

9. A photoelectric conversion apparatus, comprising a processing module, a modulation module, a demodulation module, a transmit port, a receive port, and the light source according to any one of claims 1 to 8, wherein the processing module is connected to the modulation module and the demodulation module, the modulation module is connected to the light source and the transmit port, and the demodulation module is connected to the receive port;

the processing module is configured to send a first service electrical signal to the modulation module;
the light source is configured to send an optical signal to the modulation module;
the modulation module is configured to modulate the first service electrical signal onto the optical signal to obtain a first service optical signal;
the transmit port is configured to emit the first service optical signal;
the receive port is configured to receive a second service optical signal; and

the demodulation module is configured to demodulate the second service optical signal into a second service electrical signal, and send the second service electrical signal to the processing module.

10. An optical communication device, comprising an outer housing, a processor, and the photoelectric conversion apparatus according to claim 9, wherein the outer housing is configured to fasten the processor to the photoelectric conversion apparatus, and the processor is connected to the photoelectric conversion apparatus; and
the processor is configured to send the first service electrical signal to the photoelectric conversion apparatus, and is further configured to receive the second service electrical signal from the photoelectric conversion apparatus.

11. A radar, comprising a controller, a receiving apparatus, and the light source according to any one of claims 1 to 8, wherein the controller is connected to the light source and the receiving apparatus;

the light source is configured to emit a laser beam;
the receiving apparatus is configured to receive an echo light beam, and is configured to perform photoelectric conversion on the echo light beam to obtain a detection electrical signal, wherein a to-be-detected object is configured to reflect the laser beam to reflect the echo light beam to the receiving apparatus; and
the controller is configured to detect the to-be-detected object based on the detection electrical signal.

12. A projection system, comprising an image modulation module, a lens, and the light source according to any one of claims 1 to 8, wherein

the image modulation module is configured to receive a projected light beam from the light source, is configured to modulate the projected light beam to obtain a modulated light beam, and is further configured to transmit the modulated light beam to the lens; and
the lens is configured to perform imaging on the modulated light beam.

13. A head-up display system, comprising an optical deflection module and the projection system according to claim 12, wherein

the projection system is configured to transmit the modulated light beam to the optical deflection module; and
the optical deflection module is configured to transmit an amplified modulated light beam to a windshield, wherein the modulated light beam reflected by the windshield forms a virtual image.

14. A transportation means, comprising a vehicle body, a windshield, a processor, and the head-up display system according to claim 13, wherein the vehicle body is configured to fasten the windshield, the processor, and the head-up display system together;

the processor is configured to transmit vehicle driving related information to the image modulation module; and
the image modulation module is configured to modulate the vehicle driving related information onto the projected light beam to obtain the modulated light beam.

Transportation means 100

ADAS 110

Computer system 140
Processor
Memory

Sensing system 120
Positioning system
Inertial measurement unit
Radar
Camera

Peripheral device 130
Wireless communication system
Vehicle-mounted computer
Microphone
Speaker

FIG. 1

FIG. 2

312

| Transistor 203 | Laser driver 204 |
|---|---|

322

First substrate 302

321

| First laser 202 | Capacitor 201 |
|---|---|

311

Y

X

Z

**FIG. 3**

312

| Transistor 203 | Laser driver 204 |
|---|---|

322

First substrate 302

| First laser 202 | Capacitor 201 |
|---|---|

321

Circuit board 401

Y

311

X

Z

**FIG. 4**

312

| Capacitor 201 | Transistor 203 | Laser driver 204 |

322

311

First substrate 302

Y

First laser 202

321

Circuit board 401

Z

X

FIG. 5

312

| Laser driver 204 |

322

First substrate 302

| Capacitor 201 | First laser 202 | Transistor 203 |

311

321

Y

Circuit board 401

Z

X

FIG. 6

FIG. 7

FIG. 8

FIG. 9

FIG. 10

FIG. 11

FIG. 12

1300

FIG. 13

1400

FIG. 14

FIG. 15

## INTERNATIONAL SEARCH REPORT

| International application No. |
| --- |
| **PCT/CN2024/106737** |

| A. | CLASSIFICATION OF SUBJECT MATTER |
| --- | --- |

H01S5/0239(2021.01)i

According to International Patent Classification (IPC) or to both national classification and IPC

| B. | FIELDS SEARCHED |
| --- | --- |

Minimum documentation searched (classification system followed by classification symbols)

IPC: H01S5

Documentation searched other than minimum documentation to the extent that such documents are included in the fields searched

Electronic data base consulted during the international search (name of data base and, where practicable, search terms used)

CNTXT, ENTXTC, CNABS, VEN: 半导体激光器, 衬底, 基底, 基板, 相对, 背面, 驱动, 芯片, 第二, 不同, 表面, 调制, 信号, 解调, semiconductor, laser, substrate, base, oppos+, back, driv+, chip?, second, different, surface, modulat+, signal, demodulat+

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 111934189 A (VERTILITE INC.) 13 November 2020 (2020-11-13) description, paragraphs 19-48, and figures 1-11 | 1-3, 5-7 |
| Y | CN 111934189 A (VERTILITE INC.) 13 November 2020 (2020-11-13) description, paragraphs 19-48, and figures 1-11 | 9-14 |
| X | JP 2013232022 A (TOPPAN PRINTING CO., LTD.) 14 November 2013 (2013-11-14) description, paragraphs 24-32, and figures 2a-2i | 1-3, 5-7 |
| Y | JP 2013232022 A (TOPPAN PRINTING CO., LTD.) 14 November 2013 (2013-11-14) description, paragraphs 24-32, and figures 2a-2i | 9-14 |
| X | CN 103376516 A (HONGFUJIN PRECISION INDUSTRY (SHENZHEN) CO., LTD. et al.) 30 October 2013 (2013-10-30) description, paragraphs 9-18, and figure 1 | 1-3, 5-7 |
| Y | CN 103376516 A (HONGFUJIN PRECISION INDUSTRY (SHENZHEN) CO., LTD. et al.) 30 October 2013 (2013-10-30) description, paragraphs 9-18, and figure 1 | 9-14 |

☑ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **22 October 2024** | **22 October 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## EP 4 742 467 A1

**INTERNATIONAL SEARCH REPORT**

International application No.

**PCT/CN2024/106737**

### C. DOCUMENTS CONSIDERED TO BE RELEVANT

| Category* | Citation of document, with indication, where appropriate, of the relevant passages | Relevant to claim No. |
|---|---|---|
| Y | CN 101764665 A (HUAWEI TECHNOLOGIES CO., LTD.) 30 June 2010 (2010-06-30) description, paragraphs 65-67, and figure 3 | 9-14 |
| A | CN 106256055 A (SONY CORP.) 21 December 2016 (2016-12-21) entire document | 1-14 |
| A | CN 216055673 U (SHARP ZHISHU LIGHT (SUZHOU) TECHNOLOGY CO., LTD.) 15 March 2022 (2022-03-15) entire document | 1-14 |

Form PCT/ISA/210 (second sheet) (July 2022)

**INTERNATIONAL SEARCH REPORT**
Information on patent family members

International application No.

**PCT/CN2024/106737**

| Patent document cited in search report | | | Publication date (day/month/year) | Patent family member(s) | | | Publication date (day/month/year) |
|---|---|---|---|---|---|---|---|
| CN | 111934189 | A | 13 November 2020 | None | | | |
| JP | 2013232022 | A | 14 November 2013 | JP | 5648724 | B2 | 07 January 2015 |
| CN | 103376516 | A | 30 October 2013 | None | | | |
| CN | 101764665 | A | 30 June 2010 | None | | | |
| CN | 106256055 | A | 21 December 2016 | US | 2017170339 | A1 | 15 June 2017 |
| | | | | US | 10483413 | B2 | 19 November 2019 |
| | | | | JPWO | 2015174239 | A1 | 20 April 2017 |
| | | | | JP | 6610540 | B2 | 27 November 2019 |
| | | | | WO | 2015174239 | A1 | 19 November 2015 |
| CN | 216055673 | U | 15 March 2022 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310928570